# FASCICULE DE BREVET EUROPEEN

(11) **EP 1 600 003 B1**
(45) Date de publication et mention de la délivrance du brevet: **06.12.2017**
(21) Numéro de dépôt: 04714825.9
(22) Date de dépôt: 26.02.2004
(51) Int. Cl.: H04N 19/105, H04N 19/63, H04N 19/61, H04N 19/517, H04N 19/615, H04N 19/13, H03M 7/40

(54) **PROCEDE DE CODAGE D'UNE IMAGE VIDEO PRENANT EN COMPTE LA PARITE RELATIVE A UNE COMPOSANTE DU VECTEUR DE MOUVEMENT**
METHODE ZUR VIDEOBILDCODIERUNG MIT BERÜCKSICHTIGUNG DER PARITÄT EINER BEWEGUNGSVEKTORKOMPONENTE
METHOD FOR CODING A VIDEO IMAGE TAKING INTO ACCOUNT THE PART RELATING TO A COMPONENT OF A MOVEMENT VECTOR

(30) Priorité: 06.03.2003 FR 0302840
(43) Date de publication de la demande: 30.11.2005
(73) Titulaire: Thomson Licensing DTV, 92130 Issy-les-Moulineaux (FR)
(72) Inventeur: BOISSON, Guillaume, F-35000 Rennes (FR); THOREAU, Dominique, F-35510 Cesson-Sevigne (FR); FRANCOIS, Edouard, F-35890 Bourg-des-Comptes (FR)
(74) Mandataire: Huchet, Anne
(86) Numéro de dépôt international: PCT/FR2004/050084
(87) Numéro de publication internationale: WO 2004/082293

(56) Documents cités:
- MARPE D ET AL: "EFFICIENT ENTROPY CODING FOR VIDEO COMPRESSION BY USING CONTEXT-BASED ADAPTIVE BINARY ARITHMETIC CODING" ITG FACHBERICHTE, VDE VERLAG, BERLIN, DE, vol. 170, 28 janvier 2002 (2002-01-28), pages 297-300, XP008004830 ISSN: 0932-6022
- MARPE D ET AL: "A TWO-LAYERED WAVELET-BASED ALGORITHM FOR EFFICIENT LOSSLESS AND LOSSY IMAGE COMPRESSION" IEEE TRANSACTIONS ON CIRCUITS AND SYSTEMS FOR VIDEO TECHNOLOGY, IEEE INC. NEW YORK, US, vol. 10, no. 7, octobre 2000 (2000-10), pages 1094-1102, XP000961876 ISSN: 1051-8215
- AL-MOHIMEED M A ET AL: "MOTION ESTIMATION AND COMPENSATION BASED ON ALMOST SHIFT-INVARIANT WAVELET TRANSFORM FOR IMAGE SEQUENCE CODING" INTERNATIONAL JOURNAL OF IMAGING SYSTEMS AND TECHNOLOGY, WILEY AND SONS, NEW YORK, US, vol. 9, no. 4, 1998, pages 214-229, XP000768993 ISSN: 0899-9457
- LANGDON G G ET AL: "COMPRESSION OF BLACK-WHITE IMAGES WITH ARITHMETIC CODING" IEEE TRANSACTIONS ON COMMUNICATIONS SYSTEMS, NEW YORK, NY, US, vol. 29, no. 6, 1981, pages 858-867, XP000911809 ISSN: 0096-1965 cité dans la demande

## Description

L'invention concerne un procédé de codage d'une image vidéo dans une séquence d'images comportant une étape d'analyse spatiale de l'image et reposant sur l'utilisation de la prédiction temporelle entre images. Il s'agit plus particulièrement d'un codage entropique basé sur le contexte temporel de l'image, ce dernier exploitant des caractéristiques relatives à l'information de mouvement. Le document MARPE D ET AL: "EFFICIENT ENTROPY CODING FOR VIDEO COMPRESSION BY USING CONTEXT-BASED ADAPTIVE BINARY ARITHMETIC CODING", ITG FACHBERICHTE, VDE VERLAG, BERLIN, DE, vol. 170, 28 janvier 2002, pages 297-300 décrit un procédé de codage d'une image comportant une étape d'analyse spatiale d'une image courante pour fournir un signal de fréquence spatiale basse et des signaux de fréquence spatiale haute et réalisant une estimation d'un mouvement entre un instant courant correspondant à une image de référence pour fournir un vecteur mouvement, qui effectue un codage arithmétique d'au moins un des signaux de fréquence spatiale haute relatif à l'image courante en prenant en compte un contexte temporel basé sur l'estimation d'un mouvement. Dans les standards de codage dits hybrides, par exemple MPEG-1, MPEG-2, MPEG-4, h264, comme dans la plupart des schémas de codage sous-bande 2D+t, par exemple MC-EZBC acronyme de l'anglais Motion Compensated Embedded Zero Block Context, la première étape de la chaîne de codage consiste à tirer parti de la redondance temporelle entre images successives, avant d'exploiter la redondance spatiale au sein d'une image.

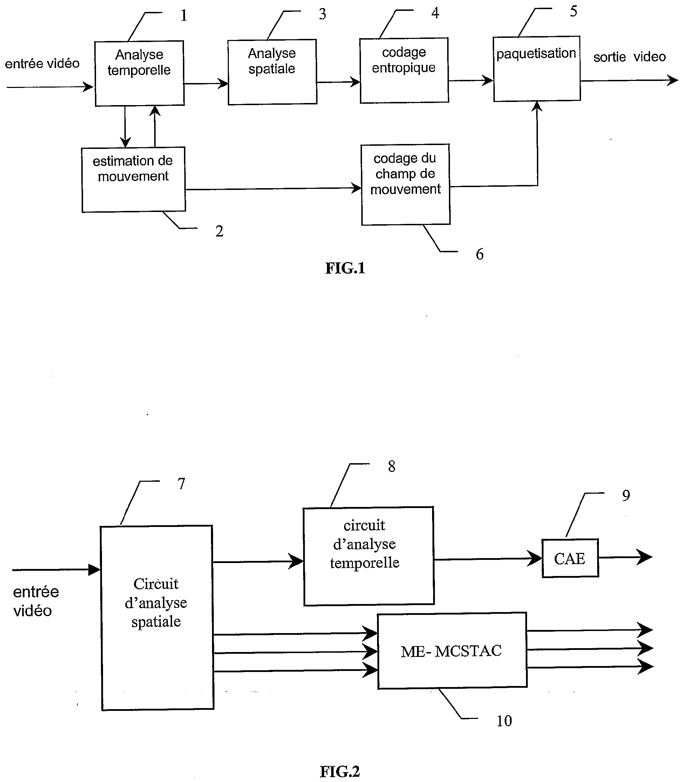

La figure 1 représente un schéma d'un codeur vidéo selon l'art antérieur.

Le signal vidéo est transmis à un circuit d'analyse temporelle 1. Un circuit d'estimation de mouvement 2 est relié à ce premier circuit pour estimer le mouvement entre deux images reçues par le codeur. Les informations de mouvement sont transmises au circuit 1 et à un circuit 6 de codage, par exemple sous forme de champs de vecteurs mouvement. La sortie du circuit 1 est transmise à un circuit d'analyse spatiale 3 qui extrait, de la texture, les coefficients de fréquence de l'image. Ces coefficients sont ensuite quantifiés puis codés par un codage entropique, circuit 4. Ces informations codées et celles de mouvement sont transmises à un circuit de mise en paquets ou paquetiseur 5 qui envoie les données vidéo sous forme de paquets vidéo pour constituer le flux de données vidéo.

Le circuit d'analyse temporelle 1 réalise une prédiction temporelle compensée en mouvement dans le cas d'un schéma hybride ou un filtrage temporel compensé en mouvement, MCTF selon l'acronyme de l'expression anglaise Motion Compensated Temporal Filtering, dans le cas d'un schéma de codage sous-bande. Les algorithmes de codage avec prédiction temporelle consistent à opérer de la compensation de mouvement pour générer des images de prédiction qui vont servir ultérieurement dans le processus de codage. Ces algorithmes reposent sur le même principe. Les images à coder sont prédites à partir d'une ou plusieurs images précédemment codées, appelées images de référence. C'est le cas dans les standards MPEG vidéo avec les images Prédites (P) et Bi-directionnelles ou Bi-prédites (B). La prédiction consiste à effectuer une compensation de mouvement à partir de ces images de référence et de vecteurs mouvement associés à l'image courante. Ce qui est ensuite codé est le résidu de la prédiction, c'est-à-dire la différence entre l'image courante et l'image de prédiction temporelle. Le mouvement est généralement décrit par blocs de pixels et la compensation en mouvement effectuée par bloc.

Le circuit d'analyse spatiale 3 réalise, par exemple, une décomposition en ondelettes ou une transformée cosinus discrète. Le codage entropique du circuit 4 peut être un codage de type VLC, de l'anglais Variable Length Coding, ou un codage de type arithmétique.

Le circuit de paquetisation a pour fonction de découper l'information de texture et de mouvement provenant respectivement du circuit de codage entropique et du circuit de codage des champs de mouvement en sous-ensembles cohérents selon leur fréquence spatiale, temporelle, et leur importance, par exemple leur poids dans une approche de codage par plans de bits. Ainsi le flux binaire obtenu est échelonnable ou "scalable" indépendamment en résolution, en fréquence trame et en fidélité.

Les champs de mouvement estimés correspondent à la résolution de la source. L'étape de compensation en mouvement du codeur ainsi que son inverse au décodeur, qu'elle soient faites par filtrage ou prédiction, doivent donc être exécutées sur des images à pleine résolution pour être cohérentes.

La scalabilité spatiale, la possibilité de transmettre et donc de reconstruire des images à différents niveaux de résolution, par exemple des images de format SD (Standard Definition), CIF ou QCIF est aujourd'hui couramment exploitée dans la transmission de données vidéo. Les schémas classiques de codage par analyse spatio-temporelle tels que celui précédemment décrit à base de décomposition en ondelettes ou de transformation cosinus discrète se prêtent à une telle scalabilité. Il ne permettent cependant pas d'adapter de manière optimale les informations de mouvement à cette scalabilité, c'est à dire aux différentes résolutions de l'image et donc d'optimiser la compression des données. Un codeur vidéo qui suit l'architecture décrite peut présenter de la scalabilité spatiale pour la texture, mais pas pour le mouvement. Or cette information de mouvement n'est pas négligeable. A titre d'exemple, elle représente environ 30% de la totalité du flux binaire lorsque l'on encode une séquence CIF 15Hz à bas débit. Les architectures usuelles souffrent donc d'une sur-définition de l'information de mouvement qui affecte sensiblement les performances de compression à basse résolution.

Des solutions existent pour préserver la scalabilité de la texture comme du mouvement. Le moyen le plus simple est d'estimer ce dernier sur la plus faible résolution spatiale admise au décodage. On procède donc en premier lieu à la décomposition spatiale. Reste ensuite à exploiter la redondance temporelle qui existe entre les hautes fréquences spatiales successives. Pour ce faire, plusieurs solutions ont été proposées, qui ont réintroduit des outils classiques de décorrélation temporelle : prédiction ou filtrage compensés en mouvement. Or ces techniques classiques sont moins efficaces dans le domaine transformé que dans le domaine pixel à cause du problème de phase générant le phénomène connu sous l'appellation anglaise de "shift-variance" des transformées spatiales. En effet, la transformée en ondelette discrète DWT (Discrete Wavelet Transform) comme la DCT (Discrete Cosine Transform) sont telles que des coefficients d'images successives, correspondant au même motif pixel, peuvent être très différents, en signe et en valeur absolue, selon la direction et l'amplitude du déplacement, la direction et la longueur du filtre spatial. La "shift-variance", intrinsèque aux transformées spatiales, nécessite une nouvelle approche d'estimation de mouvement, elle rend les hautes fréquences temporelles inadaptées au codage par prédiction ou filtrage.

L'invention a pour but de pallier les inconvénients précités. Elle a pour objet un procédé de codage d'une image dans une séquence d'images, comportant une étape d'analyse spatiale d'une image courante pour fournir un signal de fréquence spatiale basse et des signaux de fréquence spatiale haute et réalisant une estimation d'un mouvement entre un instant courant correspondant à l'image courante et un instant de référence correspondant à une image de référence pour fournir un vecteur mouvement, caractérisé en ce qu'il effectue un codage entropique d'au moins un des signaux de fréquence spatiale haute relatif à l'image courante en prenant en compte un contexte temporel basé sur l'estimation d'un mouvement, un des paramètres exploités pour le calcul du contexte temporel étant la parité relative à une composante du vecteur mouvement.

Selon une mise en oeuvre particulière, un des paramètres exploités pour le calcul du contexte temporel est la partie fractionnaire relative à une composante du vecteur mouvement.

Selon une mise en oeuvre particulière, l'étape d'analyse est une décomposition en ondelettes spatial 2D et pour un signal de fréquence spatiale haute, la composante considérée est celle dans la direction du filtrage spatial passe-haut.

Selon une mise en oeuvre particulière, le codage entropique est un codage arithmétique par plan de bit et le contexte temporel correspond au plan de bit de même niveau dans l'image de référence temporelle.

Selon une mise en oeuvre particulière, le codage arithmétique est un codage N-aire et en ce que le contexte temporel correspond à N plans de bit de même niveau dans l'image de référence temporelle.

L'invention a également pour objet un procédé de décodage d'une image dans une séquence d'images, codée selon le procédé de codage décrit ci-dessus, caractérisé en ce qu'il effectue un décodage entropique relatif à au moins un des signaux de fréquence spatiale haute en prenant en compte un contexte temporel basé sur l'estimation de mouvement, un des paramètres exploité pour le calcul du contexte temporel étant la parité relative à une composante du vecteur mouvement.

Selon une mise en oeuvre particulière, le procédé de décodage est caractérisé en ce qu'un paramètre exploité pour le calcul du contexte est la partie fractionnaire relative à une composante du vecteur mouvement.

L'invention a également pour objet un codeur vidéo mettant en oeuvre le procédé de codage précédent, comportant un circuit d'analyse spatiale recevant un signal vidéo pour fournir un signal de fréquence spatiale la plus faible correspondant à la résolution la plus faible et des signaux de fréquence spatiale haute pour une ou plusieurs résolutions supérieures, un circuit d'estimation de mouvement pour le calcul de vecteurs mouvement, caractérisé en ce qu'il comprend un circuit de codage entropique d'au moins un des signaux de fréquence spatiale haute prenant en compte un contexte temporel basé sur l'estimation d'un mouvement, un des paramètres exploités pour le calcul du contexte temporel étant la parité relative à une composante du vecteur mouvement.

L'invention a également pour objet un décodeur vidéo d'une image dans une séquence d'images, codée selon le procédé de codage précédent, caractérisé en ce qu'il comprend un circuit de décodage entropique mettant en oeuvre un algorithme de calcul d'un contexte temporel basé sur l'estimation de mouvement, un des paramètres exploité pour le calcul du contexte temporel étant la parité relative à une composante du vecteur mouvement.

Le procédé permet de tirer meilleur parti de la redondance temporelle des transformées spatiales des images successives, en particulier des hautes fréquences, tout en gardant la scalabilité spatiale du mouvement et de la texture. Grâce à la description multi-résolution du mouvement, les performances de compression en débit-qualité, pour chaque résolution de la scalabilité spatiale, sont améliorées.

La qualité visuelle et objective de la vidéo décodée est également améliorée grâce à l'utilisation de la redondance temporelle sans filtrage ou prédiction, qui sont sources d'artefacts, par exemple les effets de blocs si l'estimation de mouvement est effectuée par blocs.

D'autres particularités et avantages de l'invention ressortiront mieux dans la description suivante donnée à titre d'exemple non limitatif et faite en regard des figures annexées qui représentent :
- la figure 1 un schéma de codage selon l'art antérieur,
- la figure 2, un schéma simplifié d'un circuit de codage selon l'invention,
- la figure 3, un voisinage temporel pour un pixel (x, y) d'une image courante,
- la figure 4, un voisinage temporel et spatial pour un pixel (x, y)
- la figure 5, deux voisinages temporels pour un pixel (x,y)
- la figure 6, le voisinage spatial et temporel d'un pixel (m, n),
- la figure 7, la parité et la partie fractionnaire des composantes du vecteur mouvement,
- la figure 8 un schéma d'un circuit de codage selon l'invention.

Un circuit de codage mettant en oeuvre le procédé de codage selon l'invention est représenté à la figure 2. Le cas, non limitatif, d'une décomposition en ondelettes est choisi.

La source vidéo est transmise à un circuit d'analyse spatiale 2D référencé 7 qui est donc un circuit de décomposition en ondelettes. Il réalise une décomposition spatiale pour fournir des coefficients de sous-bande de différentes résolutions spatiales. Une première sortie fournissant les coefficients de plus basse résolution est reliée à un circuit d'analyse temporelle 8. Les autres sorties correspondant aux coefficients de sous-bande de plus haute résolution sont reliées aux entrées d'un circuit de codage arithmétique exploitant le contexte spatio-temporel compensé en mouvement ou circuit MC-STAC choisi de l'anglais Motion Compensated Spatio-Temporel Arithmetic Coding. Le circuit d'analyse temporelle 8 est reliée à un circuit de codage arithmétique basé contexte 9 ou circuit CAE de l'anglais Context-based Arithmetic Encoding. Les sorties du circuit MC-STAC correspondent aux différentes résolutions.

Le circuit de décomposition en ondelettes spatial 2D génère, à partir d'une image vidéo, des images de coefficients ondelette ou sous-images correspondant chacune à une bande fréquentielle spatiale donnée jusqu'à atteindre la plus faible résolution admise au décodage. Il décompose l'image en bande de base ou bande basse (LL) et en bandes hautes (LH, HL, HH), dans le domaine spatial.

Seules les images correspondant à la bande de base sont traitées par le circuit d'analyse temporelle 8. Le signal de plus faible résolution spatiale (LL) provenant du circuit d'analyse spatiale 7 est donc transmis au circuit d'analyse temporelle 8. Ce circuit réalise une estimation de mouvement puis un filtrage temporel compensé en mouvement, aussi appelé MCTF. L'analyse temporelle consiste en la réalisation d'images intermédiaires à partir des images reçues à la fréquence d'entrée pour obtenir une échelonnabilité temporelle. Un tel circuit d'analyse est par exemple du type MC-lift, expliqué plus loin. Le filtrage temporel consiste par exemple en la soustraction de l'image courante à une image prédite à partir d'une image précédente compensée en mouvement.

Les images autres que celles correspondant à la bande de base sont traitées par le circuit de codage arithmétique avec contexte spatio-temporel compensé en mouvement 10 ou MCSTAC. En effet, ces sous-bandes, nécessaires à la reconstruction des résolutions successives jusqu'à la résolution originale, ne sont pas propices à une technique classique de filtrage ou prédiction temporelle et sont donc tout de suite encodées arithmétiquement. Afin d'utiliser la redondance temporelle résiduelle qui lie les hautes fréquences spatiales successives, cette étape de codage arithmétique contextuel adaptatif fait intervenir une information de mouvement comme expliqué ci-après.

La distribution des coefficients ondelettes d'une haute fréquence spatiale est la suivante : de grandes régions connexes de zéros, ou de coefficients de faible amplitude, qui correspondent aux zones uniformes de l'image, sont séparées par les contours, qui sont classiquement des courbes continues, le long desquels l'amplitude des coefficients varie fortement, de même que leur signe.

Ainsi la donnée du contexte spatial, largement répandue dans les schémas existants, permet-elle de rendre plus probables l'amplitude et le signe des coefficients à coder, donc de diminuer l'entropie de la sous-bande et d'accroître le taux de compression. Un algorithme de fonctionnement du codage arithmétique contextuel basé sur le contexte spatial est par exemple décrit dans l'article de G. Langdon et J. Rissanen intitulé "Compression of black-white images with arithmetic coding", IEEE Transactions on Communications, vol.29, no.6, pp 858-867, June 1981. Ce codage arithmétique est contextuel car l'estimation et l'utilisation des tables de probabilités, au lieu d'être globales pour l'ensemble de signal, sont fonction du contexte, c'est à dire adaptées localement selon une classification des configurations possibles du voisinage. Ce genre de codage convient très bien pour coder des coefficients de haute fréquence d'une DCT ou d'une DWT spatiale, car il tire parti de la corrélation spatiale locale résiduelle. Les différents contextes sont habituellement déterminés par une combinaison des valeurs possibles des voisins immédiats. Le codage arithmétique est adaptatif car l'estimation des statistiques s'effectue par apprentissage, pendant l'encodage, à partir d'une valeur d'initialisation.

Quant à la mise en oeuvre de la dimension temporelle du contexte selon les procédés connus, elle n'est pas d'une grande efficacité. Malgré la plus grande richesse en information qu'un contexte strictement spatial, la donnée des coefficients pointés par le vecteur mouvement peut être déroutante pour la phase d'apprentissage des statistiques à cause du phénomène de shift-variance que l'on a évoqué plus haut. Selon la dynamique de la variation spatiale, le déplacement et la longueur du filtre spatial, les coefficients ondelettes ou DCT d'un motif pixel et de son translaté auront des amplitudes et un signe a priori différents. Si le déplacement est d'un nombre pair de pixels entiers, les transformées seront "en phase"; si le déplacement est d'un nombre impair de pixels entiers, les transformées seront "en opposition de phase"; etc. Ce raisonnement peut être poursuivi quelle que soit la précision sous-pixel du mouvement estimé. C'est cette information discriminante que nous proposons de joindre de manière innovante au contexte spatio-temporel, afin de permettre à l'évaluation des statistiques de la succession des hautes fréquences de converger au mieux vers sa distribution conditionnelle.

L'approche proposée consiste à utiliser un codage entropique contextuel, le contexte intégrant un contexte temporel.

Le codage entropique est le codage arithmétique permettant d'utiliser, pour des valeurs hautement probables, une longueur moyenne de code inférieure à un bit. Un point essentiel du codage entropique est la détermination de tables de probabilités caractérisant les statistiques du signal à coder.

Faisons tout d'abord un bref rappel sur la constitution d'une table de probabilité adaptative prenant en compte par exemple le contexte spatial. Considérons le cas d'un codage par plan de bits. Dans ce cas, les valeurs prises en compte dans le codage et le contexte sont binaires : 0 ou 1.

On considère les valeurs des pixels entourant le pixel courant et qui viennent d'être traités, par exemple les trois pixels les plus voisins. On dispose donc d'une liste de 2³= 8 contextes différents. A chaque contexte est associée une table de probabilités. Ces tables de probabilité sont adaptatives, c'est-à-dire mises à jour au fur et à mesure de l'encodage, selon les valeurs des coefficients traités. L'algorithme de codage se déroule, parcourant les coefficients de l'image dans un ordre prédéfini. A chaque étape du parcours, un contexte est caractérisé par son nombre d'occurrences jusqu'à l'instant considéré, ainsi que le nombre de fois, parmi ces occurrences, où la valeur 1 (ou 0) a été rencontrée. Ainsi, lors du codage d'un bit courant relatif à un plan de bits d'un élément donné, si le contexte de cet élément est Cj, le nombre d'occurrences relatif à Cj est incrémenté et le nombre de fois où la valeur 1 est rencontrée est incrémenté si la valeur du bit est 1. La probabilité d'obtenir un "zéro" ou un "un" dans le contexte Cj est calculée de la manière suivante : La probabilité d'obtenir un zéro (p₀) est égale au nombre de zéros rencontrés pour le contexte donné divisé par le nombre d'occurrences totales de ce contexte. Ainsi, le bit courant x dans le contexte Cj est codé sachant la probabilité pₓ de ce bit dans le contexte Cj.

On propose ici d'opérer un codage entropique en utilisant différentes statistiques du signal, les tables de probabilité, en fonction du contexte spatio-temporel.

Notons *I_{prec}* l'image précédente et *I_{cour}* l'image courante à coder. Ces images ne sont pas nécessairement des images de luminance; elles peuvent être des images de coefficients ondelettes, des champs de mouvement, etc.

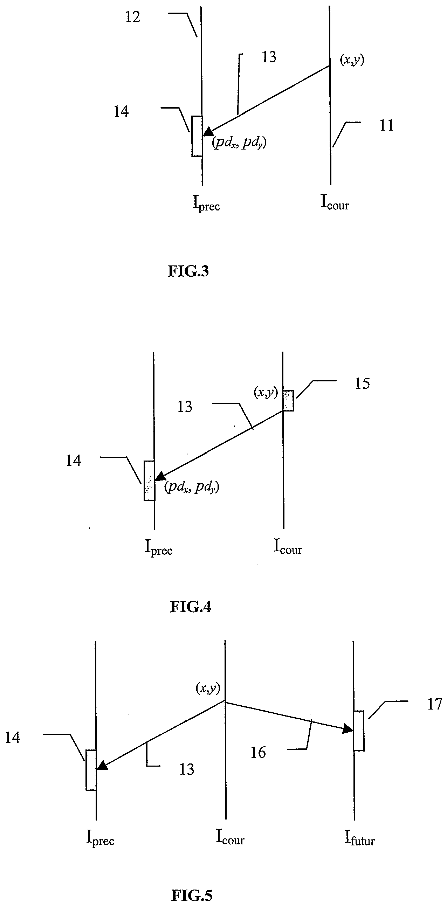

Ces images sont référencées respectivement 12 et 11 sur la figure 3 qui représente un voisinage temporel d'un pixel (x, y) d'une image courante. En tout pixel (*x*,*y*) de cette image courante, la donnée à traiter va être codée en fonction de son voisinage temporel. Ce voisinage temporel correspond aux données de l'image précédente, localisées dans le voisinage du pixel déplacé (*pdₓ*, *pd_{y}*) référencé 14, c'est-à-dire pointé par le vecteur mouvement du pixel (*x*,*y*) référencé 13 sur cette figure 3.

Le contexte temporel, noté *C*(*pdₓ, pd_{y}*) est une fonction des données du voisinage temporel. Pour alléger les notations, *C*(*pdₓ, pd_{y}*) sera noté *C* dans la suite. Selon le nombre *k* de coefficients considérés dans le contexte temporel, on disposera d'une liste de 2^{k} contextes. Pour chaque contexte, on définit de manière adaptative une table de probabilité, de la même manière que cela a été décrit dans le cas d'un contexte temporel.

Il est bien sûr possible d'utiliser des champs de mouvement différents par plan de bits, en exploitant par exemple une description grossière du mouvement pour le premier plan de bit, une version affinée pour le second plan de bit, et ainsi de suite.

L'utilisation d'un contexte temporel peut être combinée à l'utilisation d'un contexte spatial. Si l'on note j le nombre de coefficients qui composent le contexte spatial, et k le nombre de coefficients qui constituent le contexte temporel, on dispose alors d'une liste de 2^{j+k} contextes.

La figure 4 illustre un voisinage temporel 14 défini à partir du vecteur mouvement 13 associé au pixel (x, y) de coordonnées (x, y) et combiné à un voisinage spatial 15 autour de ce pixel (x, y).

Selon le même principe, on peut envisager l'utilisation de plusieurs contextes temporels, de façon similaire à de la prédiction à partir de plusieurs images de référence, telle qu'utilisée dans les standards MPEG avec les images Bi-directionnelles. La figure 5 représente une image précédente et une image suivante autour de l'image courante. Le vecteur de mouvement anticipé (forward dans la norme MPEG) 13 permet de définir le voisinage temporel 14 relatif à l'image précédente I_{prec} et le vecteur de mouvement différé (backward) 16 permet de définir le voisinage temporel 17 relatif à l'image suivante I_{futur}.

Un des aspects majeurs de l'invention concerne le type de paramètres exploités pour définir le contexte spatio-temporel. Le phénomène de "shift-variance", décrit plus haut, tend à « désorienter » un codec arithmétique contextuel. Pour que l'adaptation des tables de probabilités ne souffre pas de ce phénomène, des paramètres déterminants de la "shift-variance" sont incorporés dans la donnée du contexte.

Les paramètres considérés sont donc tout ou partie des paramètres suivants :
- un voisinage spatial d'un nombre donné de coefficients,
- un voisinage temporel compensé en mouvement de coefficients d'un autre échantillon temporel, déjà codé, de la sous-bande spatiale considérée,
- la parité d'au moins une des composantes du déplacement, selon la direction de filtrage passe-haut de la sous-bande spatiale considérée,
- la partie fractionnaire d'au moins une des composantes du déplacement, selon la direction de filtrage passe-haut de la sous-bande spatiale considérée.

La parité de la partie entière du déplacement permet de distinguer les cas où voisinages temporel et spatial sont en phase et en opposition de phase, la partie fractionnaire du déplacement permet d'aiguiser cette information de « déphasage » induit par le déplacement. Enfin, pour ces paramètres, il est avantageux de ne considérer que la composante dans la direction du filtrage passe-haut, car discriminante. Il s'agit de la composante verticale pour la sous-bande de détails horizontaux (LH) et de la composante horizontale pour la sous-bande de détails verticaux (HL). La sous-bande de détails diagonaux (HH) est particulière en ceci qu'elle possède deux directions de filtrage, orientées respectivement à +45° et -45°. Pour cette bande, on peut considérer à la fois les deux composantes, ce qui augmente le nombre de contextes, ou bien, pour limiter ce nombre, utiliser des fonctions des paramètres des deux composantes. On peut ainsi considérer par exemple l'amplitude du déplacement ou plus simplement la somme des deux composantes ou encore ne retenir que celle de plus grande amplitude. S'il s'agit de l'amplitude de déplacement, la parité est relative à la distance diagonale entre deux pixels voisins.

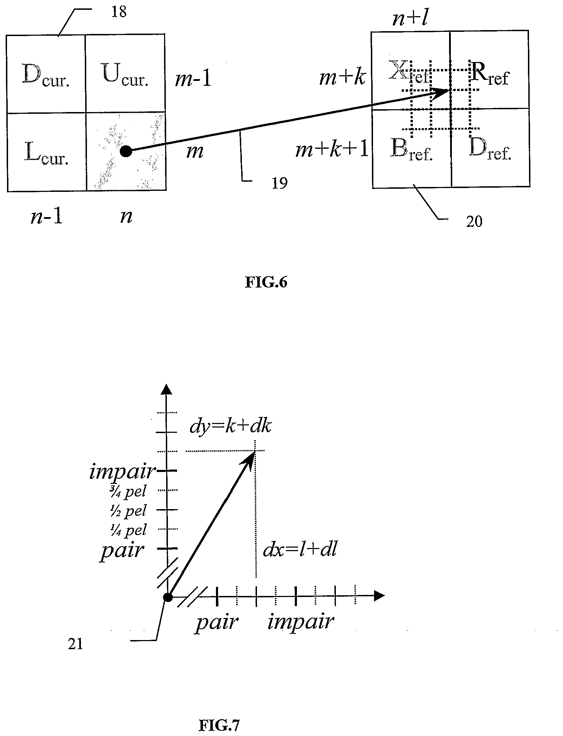

La figure 6 représente un exemple de voisinage spatio-temporel, dans le cas d'un nombre restreint de coefficients voisins pour chaque contexte et d'une précision de mouvement raisonnable d'un quart de pixel. Le voisinage spatial 18 d'un coefficient courant (m, n) situé sur la ligne m et la colonne n de l'image courante, représenté en grisé, correspond à trois coefficients voisins précédemment traités L_{cur}, U_{cur} et D_{cur}. Le voisinage temporel 20 correspond aux quatre coefficients X_{ref}, B_{ref}, R_{ref} et D_{ref} désignés par le vecteur mouvement 19 pointant dans l'image de référence. Le coefficient X_{ref} est situé sur la ligne m+k et colonne n+l.

La figure 7 représente les paramètres relatifs aux composantes du vecteur déplacement. La graduation des axes, sur le repère orthonormé 21, correspond au quart de la distance entre deux pixels. La parité est relative aux composantes du vecteur mouvement. La grille de suréchantillonnage autour de l'extrémité du vecteur mouvement permet de déterminer les parties fractionnaires correspondantes, Fract_{dx}=dl et Fract_{dy} =dk, 2 quarts de fraction en horizontal et un quart de fraction en vertical dans l'exemple de la figure 6.

dx = l+dl est la composante horizontale du vecteur, dy = k + dk est la composante verticale du vecteur.

Les parités des composantes horizontales et verticales sont respectivement Parₓ = l mod2 et Par_{y} = k mod2. Les coefficients sont en phase ou en opposition de phase selon qu'il y a parité ou non-parité.

Les coefficients ondelette sont codifiés par plans de bits. Pour chaque plan de bit, la significance des coefficients L, U et D ainsi que celle des coefficients X, B, R et D est déterminée. Il s'agit de mesurer si la valeur d'un coefficient est supérieure à la valeur correspondant au poids du bit relatif au plan traité. Les informations de fractionnement et de parité sont également relevées. On peut donc indexer les contextes de manière générique avec le train binaire suivant :

| | | | | | | | | | | |
|---|---|---|---|---|---|---|---|---|---|---|
| L_{cur} | U_{cur} | D_{cur} | Frac_{dx} | Frac_{dy} | Parₓ | Par_{y} | X_{ref} | B_{ref} | R_{ref} | D_{ref} |

Les parties fractionnaires sont codées chacune sur 2 bits (0 à 3 quarts de pixels), les autres paramètres sur 1 bit.

Il est bien sûr possible de prendre en compte les paramètres parité et fractionnement de plusieurs vecteurs, dans le cas ou plus d'un vecteur mouvement est associé à un coefficient ou un pixel, par exemple lorsque plusieurs images de référence sont exploitées.

L'estimation de mouvement du circuit d'analyse temporelle 8 est effectuée de manière classique sur les bandes basse fréquence transmises en entrée de ce circuit.

Le procédé d'estimation de mouvement (ME) mis en oeuvre par le circuit ME-MCSTAC 10 peut être effectué selon différentes approches, par exemple :
- estimation de mouvement sur les bandes de basse fréquence successives.
- estimation de mouvement directement sur les bandes de hautes fréquences.

Le premier cas est le plus simple à implémenter. A chaque étape de la décomposition spatiale, un champ de mouvement est estimé sur la basse fréquence, avant que celle-ci soit à nouveau scindée en quatre sous-bandes. Comme la source est alors assimilable au domaine pixel, cette estimation peut être effectuée de manière classique, par minimisation de l'erreur de prédiction.

Le mouvement est alors cohérent en résolution car à la dimension des trois bandes de haute fréquence à coder avec MC-STAC, et contient bien l'information de déplacement à la précision voulue.

Ainsi, le mouvement estimé sur la résolution e.g. CIF sert à coder avec MC-STAC les trois bandes de détails horizontaux, verticaux et diagonaux qui servent à passer de la résolution CIF à SD. De la même manière, le mouvement estimé sur la résolution QCIF, en plus de servir de support au MCTF classique pour la séquence à la résolution QCIF, permet de coder avec MC-STAC les trois bandes de détails horizontaux, verticaux et diagonaux qui servent à passer de la résolution QCIF à CIF. Comme on la verra plus loin, la figure 9 décrit un codeur exploitant cette solution.

On peut également vouloir se doter de champs de mouvement plus dédiés à l'application MC-STAC. Il faut alors estimer le mouvement sur chaque bande de haute fréquence à coder, c'est le deuxième cas. Comme les hautes fréquences contiennent moins d'information que les basses fréquences, il est raisonnable de penser que les champs estimés sur les hautes fréquences sont moins coûteux que celui estimés sur la basse fréquence. Néanmoins, à cause du phénomène de shift-variance décrit plus haut, le critère utilisé pour l'estimation ne peut plus consister en une simple minimisation de DFD. Le critère choisi est la minimisation de l'entropie conditionnelle implicitement liée à MCSTAC. Un tel critère correspond à un choix de vecteur a posteriori, et peut être très coûteux en ressource et complexité. Il s'agit cependant évidemment du critère optimal. Un autre critère est la minimisation de la différence des valeurs absolues. Il s'agit d'un critère très simple qui permet de passer outre un premier obstacle de la shift-variance.

Ces estimations de mouvement peuvent également être effectuées par plan de bit.

Le circuit d'analyse temporelle 8 s'appuie, dans un exemple, sur une technique connue appelée "MC-Lift", de l'anglais Motion Compensated Lifting, pour obtenir des images avec les résolutions temporelles souhaitées. Le MC-Lift consiste à construire, pour un groupe d'images, différents niveaux de résolution temporelle. Pour chaque résolution temporelle, excepté la première, les images sont construites par prédiction temporelle à partir des images de la résolution temporelle inférieure.

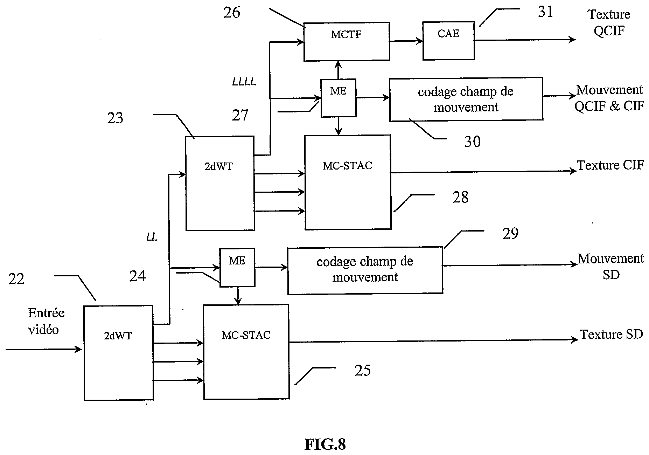

La figure 8 décrit de manière plus détaillée un dispositif mettant en oeuvre le procédé selon l'invention.

L'entrée vidéo du codeur est reliée à un circuit 22 de transformée ondelette 2D (2dWT) qui fournit en sortie la bande basse LL et les bandes hautes LH, HL et HH. La bande basse LL est reliée à un deuxième circuit 23 de transformée ondelette 2D et à un circuit d'estimation de mouvement ME 24. Les bandes hautes LH, HL et HH sont reliées à un circuit MC-STAC 25. Le deuxième circuit de transformée ondelette 2D 23 fournit, sur une sortie, la bande basse LLLL et, sur les autres sorties, les bandes hautes LLLH, LLHL et LLHH. La bande basse LLLL est reliée à un circuit MCTF 26 et à un circuit d'estimation de mouvement ME 27. Les bandes hautes sont reliées à un deuxième circuit MC-STAC 28.

Les informations de mouvement du circuit ME 24 sont transmises au circuit MC-STAC 25 et les informations de mouvement du circuit ME 27 sont transmises au circuit MCTF 26 et au circuit MC-STAC 28.

Les sorties des circuits MC-STAC 25 et 28 fournissent les textures aux résolutions SD et CIF. Les sorties des circuits ME 24 et 27 sont reliées respectivement à des circuits de codage du champ de mouvement 29 et 30 qui fournissent les informations de mouvement SD pour le circuit 29, QCIF et CIF pour le circuit 30. La sortie du circuit MCTF 26 est reliée à un circuit de codage arithmétique basé contexte CAE 31 qui réalise un codage entropique pour fournir la texture codée de résolution QCIF en sa sortie.

Ainsi, le signal d'entrée vidéo subit une décomposition ondelettes pyramidale, par le circuit 22 puis le circuit 23. Les estimations de mouvement, comme indiqué plus haut, sont réalisées sur les bandes basses. L'estimation de mouvement calculée sur une bande basse de résolution spatiale donnée est exploitée par les circuits de codage arithmétique avec contexte spatio-temporel compensé en mouvement MC-STAC codant les bandes hautes de résolution correspondant à cette bande basse.

La bande de base LLLL est traitée de manière classique par le circuit MCTF 26 qui réalise un filtrage temporel compensé en mouvement.

Les procédés et circuits de décodage mettant en oeuvre l'invention correspondent aux procédés et circuits de codage précédemment décrit.

Ainsi, le procédé de décodage calcule un contexte en s'appuyant sur les informations du flux de données codées selon le procédé de codage décrit. Ces informations, déjà décodées lors du traitement du coefficient courant, permettent de calculer et de mettre à jour en permanence les listes de contextes, pour les différents paramètres choisis au codage, pour le calcul de ce coefficient.

Le circuit de décodage entropique met en oeuvre un algorithme de calcul des tables de probabilité et du contexte selon le procédé précédant.

Le codage décrit est un codage par plan de bit, donc binaire. Il est également envisageable d'exploiter un codage N-aire, c'est à dire réalisant le codage simultané de N plans de bit. Les contextes exploités prennent alors en compte, non pas une valeur binaire, celle du plan de bit, mais la valeur N-aire comportant N bits. La liste des contextes différents qui en résultent est plus importante, augmentant le nombre de calculs, mais l'efficacité de codage est améliorée.

La description concerne un schéma "full scalable", c'est à dire présentant une échelonnabilité à la fois spatiale, temporelle et en fidélité, permettant à n'importe quel décodeur d'exploiter le flux de codage. Un autre type de schéma, par exemple ne présentant pas une échelonnabilité temporelle, ne sortirait pas du domaine de l'invention

Le codage entropique à partir du contexte temporel est décrit sur les seules hautes fréquences spatiales, les basses fréquences spatiales se prêtant à un filtrage temporel à partir d'une image prédite. Il est bien sûr envisageable, sans sortir du domaine de l'invention, d'appliquer un tel codage entropique sur l'ensemble des fréquences spatiales du signal.

De même, l'estimation de mouvement peut être effectuée sur la bande de base ou sur l'image source.

La parité est calculée sur la partie entière de la composante. Elle pourrait également être calculée sur la valeur entière la plus proche.

Le codage entropique décrit est un codage arithmétique. Le procédé selon l'invention peut également s'appliquer sur d'autres types de codage entropique exploitant les propriétés statistiques du signal, par exemple un codage de type VLC.

Les applications de l'invention concernent la compression vidéo avec prédiction temporelle.

## Revendications

1. Procédé de codage d'une image dans une séquence d'images, comportant une étape d'analyse spatiale (7, 22, 23) d'une image courante pour fournir un signal de fréquence spatiale basse et des signaux de fréquence spatiale haute et réalisant une estimation d'un mouvement entre un instant courant correspondant à l'image courante (11) et un instant de référence correspondant à une image de référence (12) pour fournir un vecteur de mouvement (13), **caractérisé en ce qu'**il effectue un codage entropique (10, 25, 28) d'au moins un des signaux de fréquence spatiale haute relatif à l'image courante en prenant en compte un contexte temporel (14, 17, 20) basé sur l'estimation d'un mouvement, un des paramètres exploités pour le calcul du contexte temporel étant la parité (21) relative à une composante du vecteur de mouvement.

2. Codeur vidéo comprenant un circuit d'analyse spatiale d'une image courante configuré pour fournir un signal de fréquence spatiale basse et des signaux de fréquence spatiale haute, un circuit d'estimation de mouvement configuré pour estimer un mouvement entre un instant courant correspondant à l'image courante et un instant de référence correspondant à une image de référence et fournir un vecteur de mouvement, **caractérisé en ce qu'**il comprend un circuit de codage entropique d'au moins un des signaux de fréquence spatiale haute relatif à l'image courante en prenant en compte un contexte temporel basé sur l'estimation d'un mouvement, un des paramètres exploités pour le calcul du contexte temporel étant la parité relative à une composante du vecteur de mouvement.

3. Procédé selon la revendication 1 ou codeur vidéo selon la revendication 2, **caractérisé en ce qu'**un des paramètres exploités pour le calcul du contexte temporel est la partie fractionnaire (21) relative à une composante du vecteur de mouvement.

4. Procédé selon la revendication 1 ou codeur vidéo selon la revendication 2, **caractérisé en ce que**, pour un signal de fréquence spatiale haute, la composante considérée est celle dans la direction du filtrage spatial passe-haut.

5. Procédé selon la revendication 1 ou codeur vidéo selon la revendication 2, **caractérisé en ce que** le contexte temporel (14, 17, 20) est combiné à un contexte spatial (15, 18).

6. Procédé selon la revendication 1 ou codeur vidéo selon la revendication 2, **caractérisé en ce que** le contexte temporel (14, 17, 20) est basé sur plusieurs estimations de mouvement (13, 16) à partir de plusieurs images de référence (14, 17).

7. Procédé selon la revendication 1 ou codeur vidéo selon la revendication 2, **caractérisé en ce que** le codage entropique est un codage arithmétique.

8. Procédé selon la revendication 6 ou codeur vidéo selon la revendication 6, **caractérisé en ce que** le codage arithmétique est un codage par plan de bit et **en ce que** le contexte temporel correspond au plan de bit de même niveau dans l'image de référence temporelle.

9. Procédé selon la revendication 6 ou codeur vidéo selon la revendication 6, **caractérisé en ce que** le codage arithmétique est un codage N-aire et **en ce que** le contexte temporel correspond à N plans de bit de même niveau dans l'image de référence temporelle.

10. Procédé selon la revendication 1 ou codeur vidéo selon la revendication 2, **caractérisé en ce que** l'estimation de mouvement (24, 27) est effectuée à partir d'un des signaux fournis par l'analyse spatiale.

11. Procédé selon la revendication 7 ou codeur vidéo selon la revendication 7, **caractérisé en ce que** l'estimation de mouvement (24, 27) est effectuée par plan de bit et **en ce que** le contexte temporel, pour un plan de bit, est basé sur l'estimation de mouvement sur le dit plan de bit.

12. Procédé selon la revendication 1 ou codeur vidéo selon la revendication 2, **caractérisé en ce que** l'analyse spatiale est une transformation ondelettes.

13. Procédé de décodage d'une image dans une séquence d'images codée selon le procédé de codage de la revendication 1 **caractérisé en ce qu'**il effectue un décodage entropique relatif à au moins un des signaux de fréquence spatiale haute en prenant en compte un contexte temporel (14, 17, 20) basé sur l'estimation de mouvement, un des paramètres exploité pour le calcul du contexte temporel étant la parité (21) relative à une composante du vecteur de mouvement.

14. Décodeur vidéo d'une image dans une séquence d'images codée selon le procédé de codage de la revendication 1 **caractérisé en ce qu'**il comprend un circuit de décodage entropique mettant en oeuvre un algorithme de calcul d'un contexte temporel basé sur l'estimation de mouvement, un des paramètres exploité pour le calcul du contexte temporel étant la parité relative à une composante du vecteur de mouvement.

15. Procédé de décodage selon la revendication 13 ou décodeur vidéo selon la revendication 14, **caractérisé en ce qu'**un paramètre exploité pour le calcul du contexte est la partie fractionnaire (21) relative à une composante du vecteur de mouvement.

## Patentansprüche

1. Methode zur Codierung eines Bildes in einer Folge von Bildern, die einen Schritt zur räumlichen Analyse (7, 22, 23) eines aktuellen Bildes zur Lieferung eines Signals von niedriger Raumfrequenz und von Signalen von hoher Raumfrequenz umfasst, und die eine Schätzung einer Bewegung zwischen einem gegenwärtigen Moment, der dem gegenwärtigen Bild (11) entspricht, und einem Referenzmoment, der einem Referenzbild (12) entspricht, durchführt, um einen Bewegungsvektor (13) zu liefern, **dadurch gekennzeichnet, dass** sie eine Entropie-Codierung (10, 25, 28) von mindestens einem der Signale von hoher Raumfrequenz in Bezug auf das gegenwärtige Bild vornimmt, unter Berücksichtigung eines zeitlichen Kontextes (14, 17, 20) basierend auf der Schätzung einer Bewegung, wobei einer der für die Berechnung des zeitlichen Kontextes ausgewerteten Parameter die Parität (21) in Bezug auf eine Komponente des Bewegungsvektors ist.

2. Videocodierer, umfassend eine Schaltung zur räumlichen Analyse eines gegenwärtigen Bildes, die konfiguriert ist, um ein Signal von niedriger Raumfrequenz und Signale von hoher Raumfrequenz zu liefern, eine Schaltung zur Bewegungsschätzung, die konfiguriert ist, um eine Bewegung zwischen einem gegenwärtigen Moment, der einem gegenwärtigen Bild entspricht, und einem Referenzmoment, der einem Referenzbild entspricht, zu schätzen und einen Bewegungsvektor zu liefern, **dadurch gekennzeichnet, dass** er eine Schaltung zur Entropie-Codierung von mindestens einem der Signale von hoher Raumfrequenz in Bezug auf das gegenwärtige Bild umfasst, unter Berücksichtigung eines zeitlichen Kontextes basierend auf der Schätzung einer Bewegung, wobei einer der für die Berechnung des zeitlichen Kontextes ausgewerteten Parameter die Parität in Bezug auf eine Komponente des Bewegungsvektors ist.

3. Methode nach Anspruch 1 oder Videocodierer nach Anspruch 2, **dadurch gekennzeichnet, dass** einer der für die Berechnung des zeitlichen Kontextes ausgewerteten Parameter der Bruchteil (21) in Bezug auf eine Komponente des Bewegungsvektors ist.

4. Methode nach Anspruch 1 oder Videocodierer nach Anspruch 2, **dadurch gekennzeichnet, dass** für ein Signal von hoher Raumfrequenz die betrachtete Komponente jene in Richtung der räumlichen Hochpassfilterung ist.

5. Methode nach Anspruch 1 oder Videocodierer nach Anspruch 2, **dadurch gekennzeichnet, dass** der zeitliche Kontext (14, 17, 20) mit einem räumlichen Kontext (15, 18) kombiniert ist.

6. Methode nach Anspruch 1 oder Videocodierer nach Anspruch 2, **dadurch gekennzeichnet, dass** der zeitliche Kontext (14, 17, 20) auf mehreren Bewegungsschätzungen (13, 16) anhand von mehreren Referenzbildern (14, 17) basiert.

7. Methode nach Anspruch 1 oder Videocodierer nach Anspruch 2, **dadurch gekennzeichnet, dass** die Entropie-Codierung eine arithmetische Codierung ist.

8. Methode nach Anspruch 6 oder Videocodierer nach Anspruch 6, **dadurch gekennzeichnet, dass** die arithmetische Codierung eine Codierung auf Bitebene ist und dadurch, dass der zeitliche Kontext der Bitebene gleicher Stufe in dem Zeitreferenzbild entspricht.

9. Methode nach Anspruch 6 oder Videocodierer nach Anspruch 6, **dadurch gekennzeichnet, dass** die arithmetische Codierung eine N-stufige Codierung ist und dadurch, dass der zeitliche Kontext N Bitebenen gleicher Stufe in dem Zeitreferenzbild entspricht.

10. Methode nach Anspruch 1 oder Videocodierer nach Anspruch 2, **dadurch gekennzeichnet, dass** die Bewegungsschätzung (24, 27) anhand eines der durch die räumliche Analyse gelieferten Signale vorgenommen wird.

11. Methode nach Anspruch 7 oder Videocodierer nach Anspruch 7, **dadurch gekennzeichnet, dass** die Bewegungsschätzung (24, 27) durch Bitebene erfolgt und dadurch, dass der zeitliche Kontext für eine Bitebene auf der Bewegungsschätzung auf der besagten Bitebene basiert.

12. Methode nach Anspruch 1 oder Videocodierer nach Anspruch 2, **dadurch gekennzeichnet, dass** die räumliche Analyse eine Wavelet-Transformation ist.

13. Methode zur Decodierung eines Bildes in einer codierten Folge von Bildern nach der Codierungsmethode des Anspruchs 1, **dadurch gekennzeichnet, dass** sie eine Entropie-Decodierung in Bezug auf mindestens eines der Signale von hoher Raumfrequenz vornimmt, unter Berücksichtigung eines zeitlichen Kontextes (14, 17, 20) basierend auf der Bewegungsschätzung, wobei einer der für die Berechnung des zeitlichen Kontextes ausgewerteten Parameter die Parität (21) in Bezug auf eine Komponente des Bewegungsvektors ist.

14. Videodecodierer eines Bildes in einer codierten Folge von Bildern nach der Codierungsmethode des Anspruchs 1, **dadurch gekennzeichnet, dass** sie eine Schaltung zur Entropie-Decodierung umfasst, die einen Algorithmus zur Berechnung eines zeitlichen Kontextes basierend auf der Bewegungsschätzung ausführt, wobei einer der für die Berechnung des zeitlichen Kontextes ausgewerteten Parameter die Parität in Bezug auf eine Komponente des Bewegungsvektors ist.

15. Methode zur Decodierung nach Anspruch 13 oder Videodecodierer nach Anspruch 14, **dadurch gekennzeichnet, dass** einer der für die Berechnung des Kontextes ausgewerteten Parameter der Bruchteil (21) in Bezug auf eine Komponente des Bewegungsvektors ist.

## Claims

1. Method for coding an image in a sequence of images, comprising a spatial analysis step (7, 22, 23) of a current image to supply a low spatial frequency signal and high spatial frequency signals and performing an estimation of a motion between a current instant corresponding to the current image (11) and a reference instant corresponding to a reference image (12) to supply a motion vector (13), **characterised in that** it performs an entropic coding (10, 25, 28) of at least one of the high spatial frequency signals relating to the current image by taking into account a time context (14, 17, 20) based on the estimation of a motion, one of the parameters used to calculate the time context being the parity (21) relative to a motion vector component.

2. Video coder comprising a spatial analysis circuit of a current image configured to supply a low spatial frequency signal and high spatial frequency signals, a motion estimation circuit configured to estimate a motion between a current instant corresponding to the current image and a reference instant corresponding to a reference image and to supply a motion vector, **characterised in that** it comprises an entropic coding circuit of at least one of the high spatial frequency signals relating to the current image by taking into account a time context based on the estimation of a motion, one of the parameters used to calculate the time context being the parity relative to a motion vector component.

3. Method according to claim 1 or video coder according to claim 2, **characterised in that** one of the parameters used to calculate the time context is the fractional part (21) relating to a motion vector component.

4. Method according to claim 1 or video coder according to claim 2, **characterised in that**, for a high spatial frequency signal, the component considered is the one of the direction of the high-pass spatial filtering.

5. Method according to claim 1 or video coder according to claim 2, **characterised in that** the time context (14, 17, 20) is combined with a spatial context (15,18).

6. Method according to claim 1 or video coder according to claim 2, **characterised in that** the time context (14, 17, 20) is based on several motion estimations (13,16) from several reference images (14,17).

7. Method according to claim 1 or video coder according to claim 2, **characterised in that** the entropic coding is an arithmetic coding.

8. Method according to claim 6 or video coder according to claim 6, **characterised in that** the arithmetic coding is a coding by bit plane and **in that** the time context corresponds to the bit plane of the same level in the time reference image.

9. Method according to claim 6 or video coder according to claim 6, **characterised in that** the arithmetic coding is an N-ary coding and **in that** the time context corresponds to N bit planes of the same level in the time reference image.

10. Method according to claim 1 or video coder according to claim 2, **characterised in that** the motion estimation (24, 27) is performed from one of the signals supplied by the spatial analysis.

11. Method according to claim 7 or video coder according to claim 7, **characterised in that** the motion estimation (24, 27) is performed by bit plane and **in that** the time context, for a bit plane, is based on the motion estimation on said bit plane.

12. Method according to claim 1 or video coder according to claim 2, **characterised in that** the spatial analysis is a wavelet transformation.

13. Method for decoding an image in a sequence of images coded according to the coding method of claim 1, **characterised in that** it performs an entropic decoding in relation to at least one of the high spatial frequency signals by taking into account a time context (14,17, 20) based on the motion estimation, one of the parameters used to calculate the time context being the parity (21) relating to a motion vector component.

14. Video decoder of an image in a sequence of images coded according to the coding method of claim 1, **characterised in that** it comprises an entropic decoding circuit implementing a calculation algorithm of a time context based on the motion estimation, one of the parameters used to calculate the time context being the parity relating to a motion vector component.

15. Decoding method according to claim 13 or video decoder according to claim 14, **characterised in that** a parameter used to calculate the context is the fractional part (21) relating to a motion vector component.
